# EUROPEAN PATENT APPLICATION

(11) **EP 4 645 435 A1**
(43) Date of publication of application: **05.11.2025**
(21) Application number: 25171791.4
(22) Date of filing: 22.04.2025
(51) Int. Cl.: H01M 4/131, H01M 4/36, H01M 4/505, H01M 10/0525, H01M 4/58, H01M 4/02

(54) **POSITIVE ELECTRODE ACTIVE MATERIAL FOR RECHARGEABLE LITHIUM BATTERY, POSITIVE ELECTRODE INCLUDING THE SAME, AND RECHARGEABLE LITHIUM BATTERY INCLUDING THE SAME**

(30) Priority: 29.04.2024 KR 20240057075
(71) Applicant: SAMSUNG SDI CO., LTD., Yongin-si, Gyeonggi-do 17084 (KR)
(72) Inventor: Kim, Young-Ki, 17084 Yongin-si (KR); Choi, Aram, 17084 Yongin-si (KR); Kim, Sangmi, 17084 Yongin-si (KR); Doo, Sungwook, 17084 Yongin-si (KR); Kang, Gwiwoon, 17084 Yongin-si (KR); Lee, Soonrewl, 17084 Yongin-si (KR)
(74) Representative: Marks & Clerk LLP

(57) **Abstract**

Provided are a positive electrode for a rechargeable lithium battery and a rechargeable lithium battery including the same, and for example, a positive electrode for a rechargeable lithium battery, including a current collector, a first positive electrode active material layer on the current collector, and a second positive electrode active material layer on the first positive electrode active material layer. The first active material layer includes a first particle represented by Formula 1 and having the form of a single particle and a second particle represented by Formula 2, and the second positive electrode active material layer includes a third particle represented by Formula 3 and having the form of a secondary particle in which a plurality of primary particles are aggregated. The first particle is present in a greater content than the second particle.

## Description

### BACKGROUND

### 1. Field

Embodiments of the present disclosure relate to a positive electrode active material for a rechargeable lithium battery, a positive electrode including the same, and a rechargeable lithium battery including the same, and for example, to a positive electrode active material including an olivine-based lithium compound, a positive electrode active material including a spinel-based lithium compound, a positive electrode including the same, and a rechargeable lithium battery including the same.

### 2. Description of the Related Art

Lately, the rapid spread of battery-powered electronics, such as mobile phones, laptop computers, and electric vehicles, has driven a sharp rise in demand for rechargeable batteries provided with high energy density and high capacity. Accordingly, extensive research efforts are directed towards improving the performance of rechargeable lithium batteries.

Rechargeable lithium batteries include a positive electrode and a negative electrode, each including an active material that allows intercalation and deintercalation of lithium ions, and an electrolyte solution, and produce electrical energy from redox reactions that take place as lithium ions are intercalated into or deintercalated from the positive electrode and the negative electrode.

### SUMMARY

Embodiments of the present disclosure provide a positive electrode active material that is economical and has high energy density, high average voltage, and excellent lifetime.

Embodiments of the present disclosure also provide a positive electrode that is economical and has high energy density, high average voltage, and excellent lifetime.

An embodiment of the present disclosure provides a positive electrode for a rechargeable lithium battery, including a current collector, a first positive electrode active material layer on the current collector, and a second positive electrode active material layer on the first positive electrode active material layer.

The first positive electrode active material layer includes a first particle including a compound represented by Formula 1 below and having an olivine structure, and a second particle including a compound represented by Formula 2 below and having a spinel structure, and
the second positive electrode active material layer includes a third particle including a compound represented by Formula 3 below and having an olivine structure.

The first particle is in the form of a single particle, and the third particle is in the form of a secondary particle in which a plurality of primary particles are aggregated.

The first particle has a greater weight (or mass) than the second particle.

Formula 1 Liₐ₁Mn_{z1}Feₓ₁B1_{y1}PO_{4-c1}

In Formula 1 above, B1 is at least one element selected from the group consisting of Al, Ti, V, and Mg, and 0.8<a1≤1.2, 0.4≤z1≤0.8, 0.2≤x1≤0.6, 0≤y1≤0.05, and 0≤c1≤0.05 are satisfied.

Formula 2 Liₐ₂Mnₓ₂B2_{y2}O_{4-c2}

In Formula 2 above, B2 is at least one element selected from the group consisting of Al and Mg, and 0.8<a2≤1.2, 1.9≤x2≤2.05, 0≤y2≤0.05, and 0≤c2≤0.05 are satisfied.

Formula 3 Liₐ₃Mn_{z3}Feₓ₃B3_{y3}PO_{4-c3}

In Formula 3 above, B3 is at least one element selected from the group consisting of Al, Ti, V, and Mg, and 0.8<a3≤1.2, 0.4≤z3≤0.8, 0≤x3≤0.6, 0≤y3≤0.05, and 0≤c3≤0.05 are satisfied.

Another embodiment of the present disclosure provides a positive electrode for a rechargeable lithium battery, including a current collector, a first positive electrode active material layer on the current collector, and a second positive electrode active material layer on the first positive electrode active material layer.

The first positive electrode active material layer includes a first particle comprising an olivine structured compound represented by Formula 1 below and having the form of a single particle, and a second particle including a spinel structured compound represented by Formula 2 below, and a first functional additive.

The second positive electrode active material layer includes a third particle comprising an olivine structured compound Formula 3 below and having the form of a secondary particle in which a plurality of primary particles are aggregated, and a second functional additive.

The first functional additive and the second functional additive each include a conductive material and a binder.

The first functional additive in the first positive electrode active material layer has a lower weight ratio than the second functional additive in the second positive electrode active material layer.

At least some of the above and other features of the invention are set out in the claims.

### BRIEF DESCRIPTION OF THE DRAWINGS

The accompanying drawings are included to provide a further understanding of the subject matter of the present disclosure, and are incorporated in and constitute a part of this specification. The drawings illustrate embodiments of the present disclosure and, together with the description, serve to explain principles of embodiments of the present disclosure. In the drawings:
FIG. 1 is a simplified conceptual view showing a rechargeable lithium battery according to embodiments of the present disclosure;
FIGS. 2-5 are schematic views showing a rechargeable lithium battery according to an embodiment, and FIG. 2 shows a cylindrical battery, FIG. 3 shows a prismatic battery, and FIGS. 4-5 show pouch-type batteries;
FIG. 6 is a cross-sectional view showing a positive electrode for a rechargeable lithium battery according to embodiments of the present disclosure;
FIG. 7 is an enlarged view showing a first positive electrode active material layer of a rechargeable lithium battery according to embodiments of the present disclosure;
FIG. 8 is an enlarged view showing a second positive electrode active material layer of a rechargeable lithium battery according to embodiments of the present disclosure;
FIG. 9 is a pair of scanning electron microscope (SEM) images showing a first particle according to an embodiment of the present disclosure;
FIG. 10 is a pair of SEM images showing a second particle according to an embodiment of the present disclosure; and

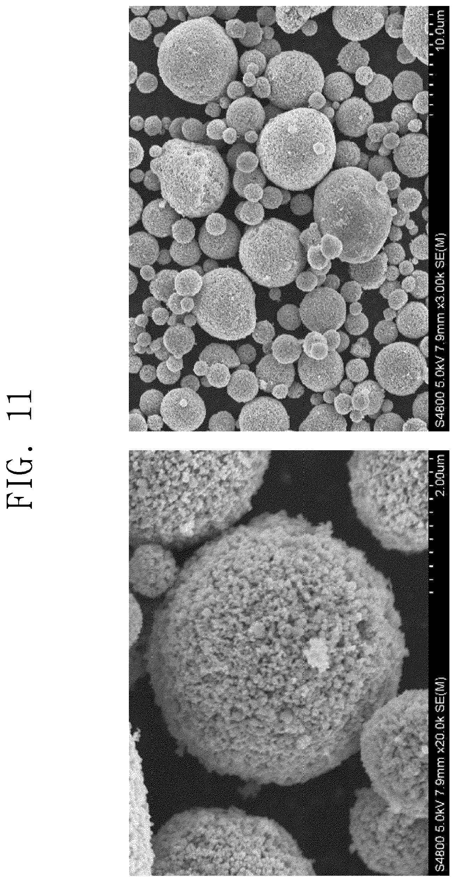

FIG. 11 is a pair of SEM images showing a third particle according to an embodiment of the present disclosure.

### DETAILED DESCRIPTION

Hereinafter, embodiments of the present disclosure will be described clearly and in more detail to such an extent that those having ordinary skill in the art easily implement the subject matter of the present disclosure. In order to sufficiently understand the configuration and effects of embodiments of the present disclosure, example embodiments of the present disclosure will be described with reference to the accompanying drawings. It should be noted, however, that the present disclosure is not limited to the following embodiments, and may be implemented in various suitable forms and variously modified. The embodiments herein are provided so that the present disclosure will be thorough and complete and will fully convey the scope of the present disclosure to those having ordinary skill in the art.

Herein, it will be understood that if a component is referred to as being on another component, the component may be directly on another component, or an intervening third component may be present. In embodiments, in the drawings, thicknesses of components may be exaggerated to effectively describe the technical contents of the present disclosure. Like reference numerals refer to like elements throughout.

Unless otherwise specified herein, the expression of a singular form may include the expression of a plural form. In embodiments, unless otherwise specified, the phrase "A or B" may indicate "A but not B", "B but not A", or "A and B". The terms "comprises" and/or "comprising" used herein do not exclude the presence or addition of one or more other components.

As used herein, the term "combination thereof" may refer to a mixture, a stack, a composite, a copolymer, an alloy, a blend, and/or a reaction product.

Unless otherwise defined herein, a particle diameter may be an average particle diameter. In embodiments, a particle diameter is defined as an average particle diameter (D50) indicating the diameter of particles having a cumulative volume of 50 volume% in the particle size distribution. The average particle diameter (D50) may be measured by any suitable method generally used in the art, for example, by a particle size analyzer, a transmission electron micrograph, and/or a scanning electron micrograph. In embodiments, an average particle diameter (D50) value may be obtained by measuring a subject using a dynamic light-scattering-based measuring device, performing data analysis, counting the number of particles for each particle size range, and then calculating the value therefrom. In embodiments, the average particle diameter (D50) may be measured using a laser diffraction method. In the measuring using the laser diffraction method, for example, target particles are distributed in a distribution solvent, introduced into a commercially available laser diffraction particle diameter measuring device (e.g., MT 3000 available from Microtrac, Ltd.), irradiated with ultrasonic waves of about 28 kHz at a power of 60 W, and then an average particle diameter (D50) based on 50% of the particle diameter distribution in the measuring device may be calculated.

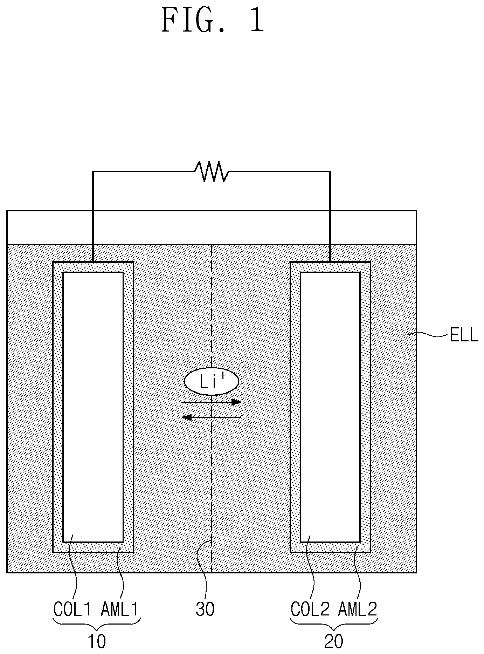

FIG. 1 is a simplified conceptual view showing a rechargeable lithium battery according to embodiments of the present disclosure. Referring to FIG. 1, the rechargeable lithium battery may include a positive electrode 10, a negative electrode 20, a separator 30, and an electrolyte solution ELL.

The positive electrode 10 and the negative electrode 20 may be spaced apart from each other by the separator 30. The separator 30 may be disposed between the positive electrode 10 and the negative electrode 20. The positive electrode 10, the negative electrode 20 and the separator 30 may be in contact with the electrolyte solution ELL. The positive electrode 10, the negative electrode 20 and the separator 30 may be impregnated in the electrolyte solution ELL.

The electrolyte solution ELL may be a medium for transferring lithium ions between the positive electrode 10 and the negative electrode 20. In the electrolyte solution ELL, the lithium ions may move through the separator 30 toward the positive electrode 10 or the negative electrode 20.

### Positive Electrode 10

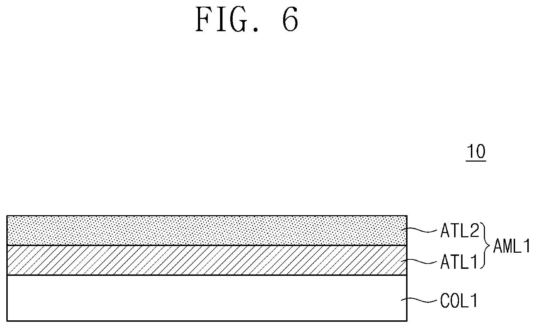

The positive electrode 10 for a rechargeable lithium battery may include a current collector COL1 and a positive electrode active material layer AML1 on the current collector. The positive electrode active material layer AML1 may include a positive electrode active material and may further include a binder and/or a conductive material (e.g., an electrically conductive material). A detailed description of the positive electrode active material layer AML1 according to embodiments of the present disclosure will be further described below with respect to FIG. 6. Al may be used as the current collector COL1, but the embodiment of the present disclosure is not limited thereto.

### Negative Electrode 20

The negative electrode 20 for a rechargeable lithium battery may include a current collector COL2 and a negative electrode active material layer AML2 on the current collector COL2. The negative electrode active material layer AML2 may include a negative electrode active material, and may further include a binder and/or a conductive material (e.g., an electrically conductive material).

For example, the negative electrode active material layer AML2 may include about 90 wt% to about 99 wt% of the negative electrode active material, about 0.5 wt% to about 5 wt% of the binder, and about 0 wt% to about 5 wt% of the conductive material.

The binder may serve to attach the negative electrode active material particles well to each other and also to attach the negative electrode active material well to the current collector COL2. The binder may include a non-aqueous binder, an aqueous binder, a dry binder, or a combination thereof.

The non-aqueous binder may include polyvinyl chloride, carboxylated polyvinyl chloride, polyvinyl fluoride, an ethylene propylene copolymer, polystyrene, polyurethane, polytetrafluoroethylene, polyvinylidene fluoride, polyethylene, polypropylene, polyamideimide, polyimide, or a combination thereof.

The aqueous binder may be selected from a styrene-butadiene rubber, a (meth)acrylated styrene-butadiene rubber, a (meth)acrylonitrile-butadiene rubber, a (meth)acrylic rubber, a butyl rubber, a fluoro rubber, polyethylene oxide, polyvinyl pyrrolidone, polyepichlorohydrin, polyphosphazene, poly(meth)acrylonitrile, an ethylene propylene diene copolymer, polyvinylpyridine, chlorosulfonated polyethylene, latex, a polyester resin, a (meth)acrylic resin, a phenol resin, an epoxy resin, polyvinyl alcohol, and a combination thereof.

When an aqueous binder is used as the negative electrode binder, a cellulose-based compound capable of imparting viscosity may be further included. The cellulose-based compound may include at least one of carboxymethyl cellulose, hydroxypropylmethyl cellulose, methyl cellulose, or an alkali metal salt thereof. The alkali metal may include Na, K, or Li.

The dry binder may be a polymer material that is capable of being fibrous. For example, the dry binder may be polytetrafluoroethylene, polyvinylidene fluoride, a polyvinylidene fluoride-hexafluoropropylene copolymer, polyethylene oxide, or a combination thereof.

The conductive material may be used to impart conductivity (e.g., electrical conductivity) to the electrode. Any material that does not cause chemical change (e.g., does not cause an undesirable chemical change in the rechargeable lithium battery) and that conducts electrons may be used in the battery. Non-limiting examples thereof may include a carbon-based material such as natural graphite, artificial graphite, carbon black, acetylene black, ketjen black, a carbon fiber, a carbon nanofiber, and a carbon nanotube; a metal-based material including copper, nickel, aluminium, silver, etc. in a form of a metal powder or a metal fiber; a conductive polymer such as a polyphenylene derivative; or a mixture thereof.

The current collector COL2 may include a copper foil, a nickel foil, a stainless steel foil, a titanium foil, a nickel foam, a copper foam, a polymer substrate coated with a conductive metal, or a combination thereof

### Negative Electrode Active Material

The negative electrode active material in the negative electrode active material layer AML2 may include a material that reversibly intercalates/deintercalates lithium ions, a lithium metal, a lithium metal alloy, a material capable of doping/dedoping lithium, or a transition metal oxide.

The material that reversibly intercalates/deintercalates lithium ions may include a carbon-based negative electrode active material, such as, for example. crystalline carbon, amorphous carbon or a combination thereof. Examples of the crystalline carbon may be graphite such as irregular, planar, flaky, spherical, or fibrous natural graphite or artificial graphite, and examples of the amorphous carbon may be soft carbon (low-temperature fired carbon), hard carbon, mesophase pitch carbide, fired cokes, and the like.

The lithium metal alloy includes an alloy of lithium and a metal selected from Na, K, Rb, Cs, Fr, Be, Mg, Ca, Sr, Si, Sb, Pb, In, Zn, Ba, Ra, Ge, Al, and Sn.

The material capable of doping/dedoping lithium may be a Si-based negative electrode active material or a Sn-based negative electrode active material. The Si-based negative electrode active material may include silicon, a silicon-carbon composite, SiOx (0 < x < 2), a Si-Q alloy (where Q is selected from an alkali metal, an alkaline-earth metal, a Group 13 element, a Group 14 element (excluding Si), a Group 15 element, a Group 16 element, a transition metal, a rare earth element, and a combination thereof). The Sn-based negative electrode active material may include Sn, SnO₂, a Sn-based alloy, or a combination thereof.

The silicon-carbon composite may be a composite of silicon and amorphous carbon. According to an embodiment, the silicon-carbon composite may be in a form of silicon particles and amorphous carbon coated on the surface of the silicon particles. For example, the silicon-carbon composite may include a secondary particle (core) in which primary silicon particles are assembled, and an amorphous carbon coating layer (shell) on the surface of the secondary particle. The amorphous carbon may also be between the primary silicon particles, and, for example, the primary silicon particles may be coated with the amorphous carbon. The secondary particle may exist dispersed in an amorphous carbon matrix.

The silicon-carbon composite may further include crystalline carbon. For example, the silicon-carbon composite may include a core including crystalline carbon and silicon particles and an amorphous carbon coating layer on a surface of the core.

The Si-based negative electrode active material or the Sn-based negative electrode active material may be used in combination with a carbon-based negative electrode active material.

### Separator 30

Depending on the type of the rechargeable lithium battery, the separator 30 may be present between the positive electrode 10 and the negative electrode 20. The separator 30 may include polyethylene, polypropylene, polyvinylidene fluoride, or a multilayer film of two or more layers thereof, and a mixed multilayer film such as a polyethylene/polypropylene two-layer separator, polyethylene/polypropylene/polyethylene three-layer separator, polypropylene/polyethylene/polypropylene three-layer separator, and the like.

The separator 30 may include a porous substrate and a coating layer including an organic material, an inorganic material, or a combination thereof on one or both surfaces of the porous substrate.

The porous substrate may be a polymer film formed of any one polymer selected from polyolefin such as polyethylene and polypropylene, polyester such as polyethylene terephthalate and polybutylene terephthalate, polyacetal, polyamide, polyimide, polycarbonate, polyether ketone, polyarylether ketone, polyetherimide, polyamideimide, polybenzimidazole, polyethersulfone, polyphenylene oxide, a cyclic olefin copolymer, polyphenylene sulfide, polyethylene naphthalate, a glass fiber, TEFLON, and polytetrafluoroethylene, or a copolymer or mixture of two or more thereof.

The organic material may include a polyvinylidene fluoride-based polymer or a (meth)acrylic polymer.

The inorganic material may include inorganic particles selected from Al₂O₃, SiO₂, TiO₂, SnO₂, CeO₂, MgO, NiO, CaO, GaO, ZnO, ZrO₂, Y₂O₃, SrTiO₃, BaTiO₃, Mg(OH)₂, boehmite, and a combination thereof, but is not limited thereto.

The organic material and the inorganic material may be mixed in one coating layer, or a coating layer including an organic material and a coating layer including an inorganic material may be stacked.

### Electrolyte Solution ELL

The electrolyte solution ELL for a rechargeable lithium battery may include a non-aqueous organic solvent and a lithium salt.

The non-aqueous organic solvent may serve as a medium for transmitting ions taking part in the electrochemical reaction of a battery.

The non-aqueous organic solvent may be a carbonate-based, ester-based, ether-based, ketone-based, or alcohol-based solvent, an aprotic solvent, or a combination thereof.

The carbonate-based solvent may include dimethyl carbonate (DMC), diethyl carbonate (DEC), dipropyl carbonate (DPC), methylpropyl carbonate (MPC), ethylpropyl carbonate (EPC), methylethyl carbonate (MEC), ethylene carbonate (EC), propylene carbonate (PC), butylene carbonate (BC), and the like.

The ester-based solvent may include methyl acetate, ethyl acetate, n-propyl acetate, dimethyl acetate, methyl propionate, ethyl propionate, decanolide, mevalonolactone, valerolactone, caprolactone, and the like.

The ether-based solvent may include dibutyl ether, tetraglyme, diglyme, dimethoxyethane, 2-methyltetrahydrofuran, 2,5-dimethyltetrahydrofuran, tetrahydrofuran, and the like. In addition, the ketone-based solvent may include cyclohexanone, and the like. The alcohol-based solvent may include ethanol, isopropyl alcohol, and the like and the aprotic solvent may include nitriles such as R-CN (wherein R is a C2 to C20 linear, branched, or cyclic hydrocarbon group, a double bond, an aromatic ring, or an ether bond), and the like; amides such as dimethylformamide; dioxolanes such as 1,3-dioxolane, 1,4-dioxolane, and the like; sulfolanes, and the like.

The non-aqueous organic solvents may be used alone or in combination of two or more.

In addition, when using a carbonate-based solvent, a cyclic carbonate and a chain carbonate may be mixed and used, and the cyclic carbonate and the chain carbonate may be mixed in a volume ratio of about 1:1 to about 1:9.

The lithium salt dissolved in the organic solvent supplies lithium ions in a battery, enables a basic operation of a rechargeable lithium battery, and improves transportation of the lithium ions between positive and negative electrodes. Examples of the lithium salt include at least one selected from LiPF₆, LiBF₄, LiSbF₆, LiAsF₆, LiClO₄, LiAlO₂, LiAlCl₄, LiPO₂F₂, LiCl, Lil, LiN(SO₃C₂F₅)₂, Li(FSO₂)₂N (lithium bis(fluorosulfonyl)imide, LiFSI), LiC₄F₉SO₃, LiN(CₓF₂ₓ₊₁SO₂)(C_{y}F_{2y+1}SO₂) (wherein x and y are integers of 1 to 20), lithium trifluoromethane sulfonate, lithium tetrafluoroethanesulfonate, lithium difluoro(oxalato)borate(LiDFOB), lithium difluorobis(oxalato)phosphate (LiDFBOP), and lithium bis(oxalato) borate (LiBOB).

### Rechargeable Lithium Battery

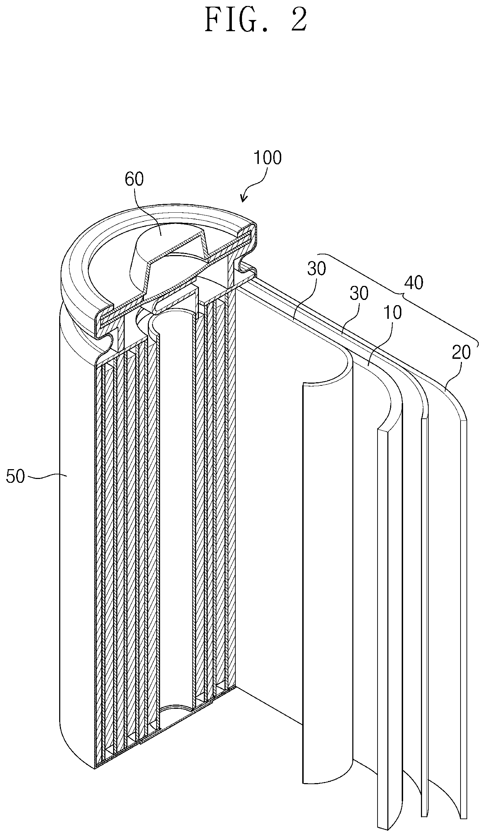

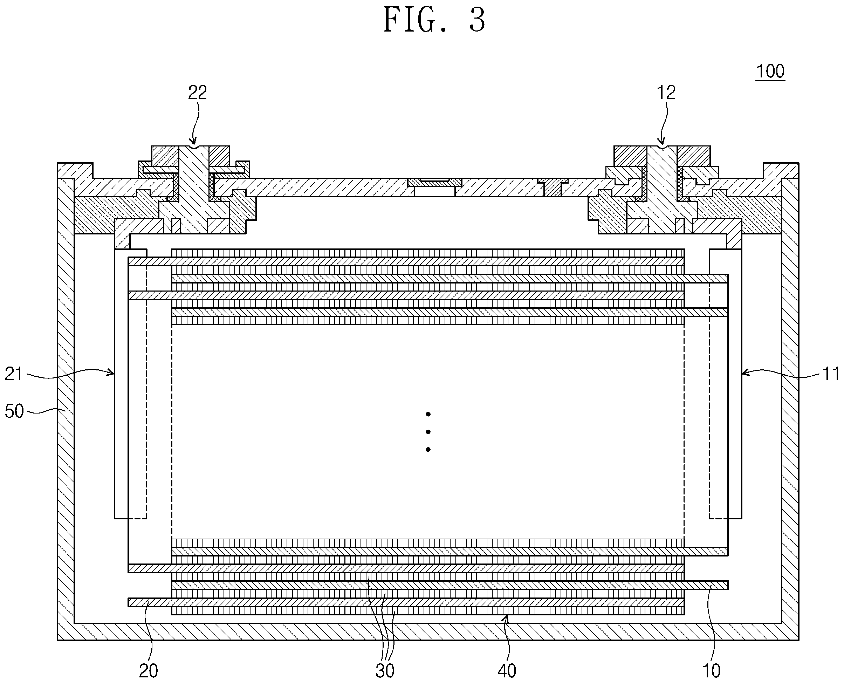

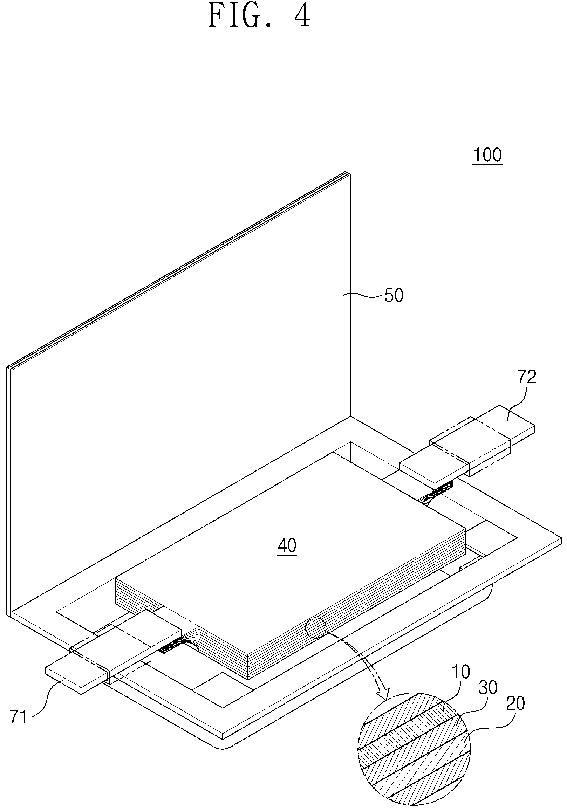

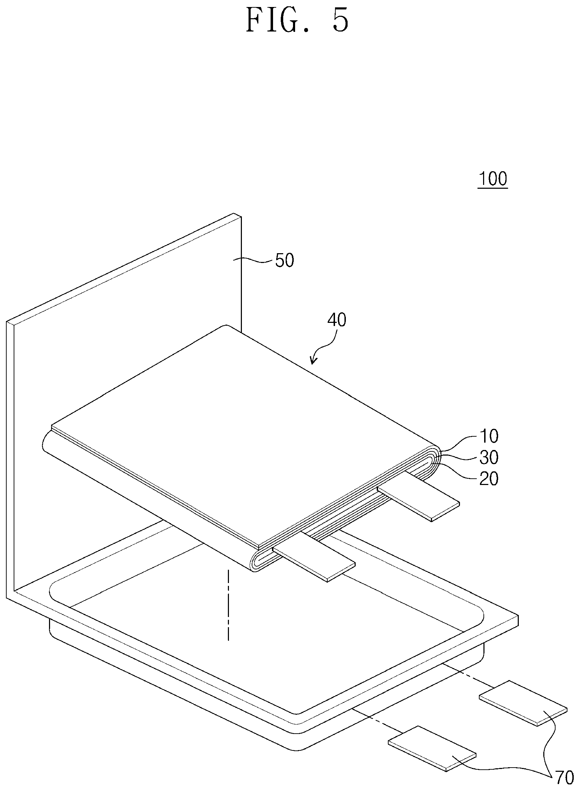

The rechargeable lithium battery may be classified into cylindrical, prismatic, pouch, or coin-type batteries, and the like depending on their shape. FIGS. 2 to 5 are schematic views illustrating a rechargeable lithium battery according to an embodiment. FIG. 2 shows a cylindrical battery, FIG. 3 shows a prismatic battery, and FIGS. 4 and 5 show pouch-type batteries. Referring to FIGS. 2 to 5, the rechargeable lithium battery 100 may include an electrode assembly 40 including a separator 30 between a positive electrode 10 and a negative electrode 20, and a case 50 in which the electrode assembly 40 is included. The positive electrode 10, the negative electrode 20, and the separator 30 may be impregnated with an electrolyte solution (not shown). The rechargeable lithium battery 100 may include a sealing member 60 sealing the case 50, as shown in FIG. 2. In FIG. 3, the rechargeable lithium battery 100 may include a positive electrode lead tab 11, a positive terminal 12, a negative electrode lead tab 21, and a negative terminal 22. As shown in FIGS. 4 and 5, the rechargeable lithium battery 100 may include an electrode tab 70, which may be, for example, a positive electrode tab 71 and a negative electrode tab 72 serving as an electrical path for inducing the current formed in the electrode assembly 40 to the outside.

The rechargeable lithium battery according to an embodiment may be applied to automobiles, mobile phones, and/or various types of electric devices, as non-limiting examples.

FIG. 6 is a cross-sectional view showing a positive electrode for a rechargeable lithium battery according to embodiments of the present disclosure. Referring to FIG. 6, the positive electrode 10 for a rechargeable lithium battery includes the current collector COL1 (see FIG. 1) and the positive electrode active material layer AML1 (see FIG. 1) as described above. The positive electrode active material layer AML1 includes a first positive electrode active material layer ATL1, and a second positive electrode active material layer ATL2 stacked on the first positive electrode active material layer ATL1.

Hereinafter, each of the first positive electrode active material layer ATL1 and the second positive electrode active material layer ATL2 will be described in more detail.

### First Positive Electrode Active Material Layer ATL1

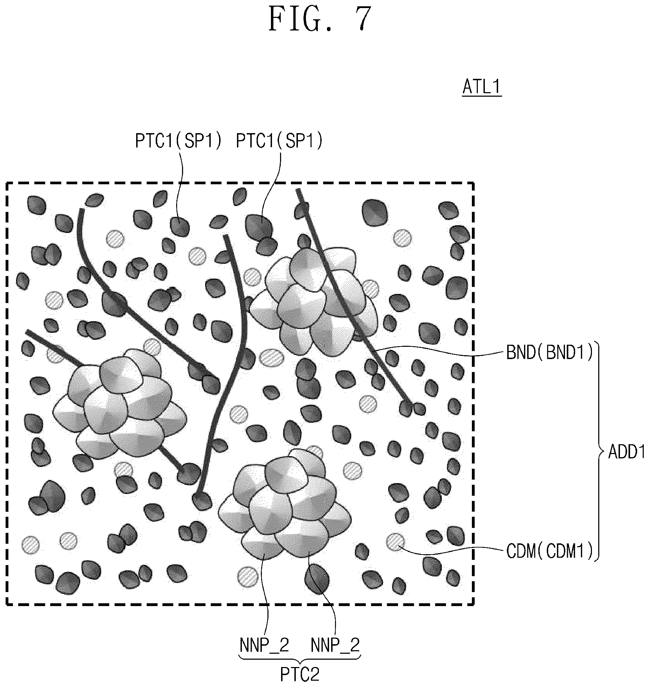

FIG. 7 is an enlarged view showing a first positive electrode active material layer ATL1 of a positive electrode for a rechargeable lithium battery according to embodiments of the present disclosure.

The first positive electrode active material layer ATL1 may include a first particle PTC1, a second particle PTC2, and a first functional additive ADD1. The first functional additive ADD1 may include a first binder BND1 and a first conductive material CDM1 (e.g., first electrically conductive material CDM1).

The first binder BND1 may combine (e.g., adhere together) the first particle PTC1 and the first conductive material CDM1. In embodiments, the first binder BND1 may stably fix the first positive electrode active material layer ATL1 to the current collector COL1. For example, the first binder BND1 may include at least one selected from the group consisting of polyvinyl alcohol, carboxymethyl cellulose, hydroxypropyl cellulose, diacetyl cellulose, polyvinyl chloride, carboxylated polyvinyl chloride, polyvinyl fluoride, an ethylene oxide-containing polymer, polyvinyl pyrrolidone, polyurethane, polytetrafluoroethylene, polyvinylidene fluoride, polyethylene, polypropylene, a styrene-butadiene rubber, a (meth)acrylated styrene-butadiene rubber, an epoxy resin, a (meth)acrylic resin, a polyester resin, and nylon, but is not limited thereto.

The first conductive material CDM1 may be used to improve conductivity (e.g., electrical conductivity) of the first positive electrode active material layer ATL1. Any suitable conductive material that does not cause chemical changes (e.g., that does not cause undesirable chemical changes) in the first positive electrode active material layer ATL1 may be used as the first conductive material CDM1 without limitation. For example, the first conductive material CDM1 may include a carbon-based material such as natural graphite, artificial graphite, carbon black, acetylene black, ketjen black, a carbon fiber, a carbon nanofiber, and/or a carbon nanotube; a metal-based material including copper, nickel, aluminium, silver, etc. in a form of a metal powder and/or a metal fiber; a conductive polymer (e.g., an electrically conductive polymer) such as a polyphenylene derivative; or a mixture thereof.

Hereinafter, each of the first particle PTC1 and the second particle PTC2 in the first positive electrode active material layer ATL1 will be described in more detail.

### First Particle PTC1

The first particle PTC1 includes an olivine-based lithium compound represented by Formula 1 below.

Formula 1 Liₐ₁Mn_{z1}Feₓ₁B1_{y1}PO_{4-c1}

In Formula 1 above, 0.8<a1≤1.2, 0.4≤z1≤0.8, 0.2≤x1≤0.6, 0≤y1≤0.05 (e.g. 0.001≤y1≤0.05), and 0≤c1≤0.05 are satisfied. B1 is at least one element selected from the group consisting of Al, Ti, V, and Mg. B1 may be a dopant with which the first particle PTC1 is doped. For example, B1 may include Ti.

The first particle PTC1 may further include carbon derived from the positive electrode active material layer AML1 described above. The first particle PTC1 may have a carbon element content of about 0.5 wt% to about 5 wt%, about 0.5 wt% to about 3 wt%, or about 0.5 wt% to about 2 wt%.

The first particle PTC1 may be in the form of a single particle. Herein, the term single particle may indicate a single type (or kind) of particle having no grain boundary inside thereof. The term single particle may indicate one single particle morphologically present in an independent phase in which particles are not aggregated with one another, a particle having a monolith structure, a particle having a one-body structure, or a non-aggregated particle. For example, the single particle may be a single crystal. In embodiments, the single particle may be a particle including several crystals. The single particle may be in an isolated form. In embodiments, the single particle may be in a form in which about 2 to about 100 first primary particles are attached to one another. For example, referring to FIG. 7, the first particle in the form of a single particle SP1 may exist as a single, isolated particle, but may also be in a form of in which two particles are attached to each other.

The first particle PTC1 may be a nanomorphous positive electrode active material. The first particle PTC1 may include at least one first primary particle. In an embodiment, the first particle PTC1 may be in the shape of sphere or oval (e.g., may be generally spherical or generally ovoid) in which first primary particles are attached. In another embodiment, the first particle PTC1 may not have a spherical shape but have an irregular shape even if the first primary particles are attached.

In an embodiment, the average particle diameter may indicate a particle diameter (D50) if a cumulative volume is about 50 volume% in a particle size distribution. In an embodiment, the average particle diameter (D50) of the first particle PTC1 may be a value measured using a particle size analyzer.

In an embodiment, the first particle PTC1 (e.g. in the form of a single particle) may have an average particle diameter of about 500 nm to about 2.5 µm, or about 1 µm. The size of at least one first primary particle constituting the first particle PTC1 may be measured using a scanning electron microscope (SEM). In an embodiment, the size of the first primary particle may indicate a diameter measured by randomly selecting about 30 first primary particles from an electron micrograph of a positive electrode active material. The first primary particle may be uniform (e.g., substantially uniform) in size. The first primary particle may have a size of about 100 nm to about 500 nm, or about 100 nm to about 200 nm.

The first particle PTC1 may be in the form of polycrystal and may include secondary particles in which at least two first primary particles are aggregated. For example, one first particle PTC1 may include a plurality of first primary particles aggregated together. The first particle PTC1 including the plurality of first primary particles may be in the shape of sphere or oval (e.g., may be generally spherical or generally ovoid).

In an embodiment, the average particle diameter may indicate a particle diameter (D50) if a cumulative volume is about 50 volume% in a particle size distribution. In an embodiment, the average particle diameter (D50) of the first particle PTC1 may be a value measured using a particle size analyzer.

The polycrystalline first particle PTC1 including at least one first primary particle may have an average particle diameter of about 500 nm to about 5 µm, about 100 nm to about 3 µm, about 500 nm to about 2.5 µm, about 3 µm to about 7 µm, about 4 µm to about 6 µm, or about 5 µm. The average particle diameter (D50) of the first particle PTC1 may be smaller than an average particle diameter (D50) of the second particle PTC2, which will be further described below.

The first particle PTC1 may include at least one primary particle (or single particle). The size of at least one first primary particle constituting the first particle PTC1 may be measured using a scanning electron microscope (SEM). In an embodiment, the size of the first primary particle may indicate a diameter measured by randomly selecting about 30 first primary particles from an electron micrograph of a positive electrode active material. The first primary particle may be uniform (e.g., substantially uniform) in size.

At least one first primary particle constituting the polycrystalline first particle PTC1 may have a size of about 100 nm to about 200 nm, about 50 nm to about 150 nm, about 50 nm to about 100 nm, about 100 nm to about 150 nm, or about 200 nm to about 300 nm.

In an embodiment, the first particle PTC1 may include a coating layer on a surface thereof. The coating layer may entirely cover the surface of the first particle PTC1, or may partially cover the surface of the first particle PTC1. For example, the coating layer may include carbon and/or a carbon-containing compound. The coating layer may further include at least one selected from the group consisting of a titanium-containing compound, a magnesium-containing compound, and a vanadium-containing compound. Metal-containing compounds, such as titanium-containing compounds, magnesium-containing compounds, and vanadium-containing compounds, may be, for example, metal oxides, metal hydroxides, metal carbonates, composites thereof, or mixtures thereof. The metal-containing compounds may further include other metals and/or non-metallic elements. For example, the metal-containing compounds may further include lithium. The first particle PTC1 may have improved structural stability and electrical conductivity due to the coating layer.

In an embodiment, the polycrystalline first particle PTC1 may further include a grain boundary coating layer on a surface of each of the first primary particles. The grain boundary coating layer may be present inside the first particle PTC1. The grain boundary coating layer may be present along an interface between the first primary particles inside the first particle PTC1. For example, the grain boundary coating layer may indicate a material applied onto a grain boundary inside the first particle PTC1.

The grain boundary coating layer may include carbon and/or a carbon-containing compound. The grain boundary coating layer may further include at least one selected from the group consisting of a titanium-containing compound, a magnesium-containing compound, and a vanadium-containing compound.

The inside of the first particle PTC1 described above may indicate the entire inside portion of the first particle PTC1 excluding the surface of the first particle PTC1. For example, the inside of the first particle PTC1 may indicate a region of the entire inside from about 10 nm in depth, or from about 10 nm to about 2 µm in depth, with respect to the surface of the first particle PTC1.

The polycrystalline first particle PTC1 may further include a grain boundary coating portion, and may thus have greater structural stability and have a uniform (e.g., substantially uniform) coating layer on the surface thereof. In embodiments, the first particle PTC1 may further include a grain boundary coating portion, and may thus have further improved electrical conductivity.

The first particle PTC1 may further include carbon derived from the coating layer and/or the grain boundary coating layer described above. The first particle PTC1 may have a carbon element content of about 0.5 wt% to about 10 wt%, about 1 wt% to about 3 wt%, or about 1.5 wt% to about 2.5 wt%. For example, the first particle PTC1 may have a greater content of carbon if in the form of a secondary particle than in the form of a single particle.

The first particle PTC1 may be in the shape of sphere (e.g., may be generally spherical) in which a plurality of first primary particles SP1 are aggregated. The first particle PTC1 may have the first primary particles SP1 closely aggregated, may thus exhibit the following characteristics. The first particle keeps the coating layer and/or the grain boundary coating layer described above well, and may thus have greater electrical conductivity and improved low-temperature characteristics. Due to the increased bindability of an electrode plate, binder capacity may be reduced (e.g., an amount of the binder utilized may be reduced). The first particle PTC1 may be in the shape of sphere or oval (e.g., may be generally spherical or generally ovoid).

The first particle PTC1 may have a porosity of about 20% to about 40%. Porosity (n) may be defined as the pore volume (Vp) divided by the total volume (Vt) of a particle (n=Vp/Vt). The porosity of the active material particles can be measured using BET (Brunauer-Emmett-Teller) analysis, which determines the specific surface area and pore structure based on gas adsorption. By measuring the amount of gas adsorbed on the material's surface at different pressures, the BET method calculates the specific surface area (SSA) and, when combined with BJH (Barrett-Joyner-Halenda) analysis, provides insights into pore size distribution and pore volume. This method is particularly useful for analyzing nanometer-scale pores (0.5-300 nm) and is widely applied in lithium-ion battery materials to evaluate electrolyte infiltration and ion diffusion pathways. A Span value of the first particle PTC1, analyzed through a particle size analyzer, may be about 0.3 to about 0.75.

### Second Particle PTC2

The second particle PTC2 includes a lithium compound having a spinel structure represented by Formula 2 below.

Formula 2 Liₐ₂Mnₓ₂B2_{y2}O_{4-c2}

In Formula 2 above, 0.8<a2≤1.2, 1.9≤x2≤2.05, 0≤y2≤0.05 (e.g. 0.001≤y2≤0.05), and 0≤c2≤0.05 are satisfied. B2 is at least one element selected from the group consisting of Al and Mg. B2 may be a dopant with which the second particle PTC2 is doped. The dopant may have the effect of controlling the uniform (e.g., substantially uniform) growth of the second primary particles NNP_2 constituting the second particle PTC2 and improve charging/discharging efficiency, low-temperature characteristics, and lifetime characteristics of a rechargeable lithium battery. The second particle PTC2 is provided with benefits including high output characteristics, high structural stability, high average voltage, and excellent lifetime characteristics.

The second particle PTC2 may have a spinel structure having a tetrahedral lattice structure and an octahedral lattice structure. The lattice structure has various suitable passages, thereby allowing lithium ions to be easily intercalated/deintercalated, resulting in excellent output characteristics. The second particle PTC2 includes Mn, and may thus be structurally stable. This structural stability protects the electrochemical properties of particles even at high voltages, thereby allowing operation at high voltages and providing excellent lifetime characteristics.

The second particle PTC2 is lithium manganese oxide and may be a positive electrode material in which cobalt is replaced with manganese in lithium cobalt oxide. In an embodiment of the present disclosure, the second particle PTC2 may have a trace content of cobalt (Co), indicating substantially no Co content. For example, the second particle PTC2 may have a cobalt (Co) content of about 100 ppm or less. The positive electrode active material according to embodiments of the present disclosure is substantially free of cobalt (Co), thereby providing a rechargeable battery that is economical and has high capacity and operating voltage.

Referring to FIG. 7, the second particle PTC2 is in the form of a polycrystal and may include secondary particles in which at least two second primary particles NNP_2 are aggregated. For example, one second particle PTC2 may include a plurality of second primary particles NNP_2 aggregated together. The second particle PTC2 including the plurality of second primary particles NNP_2 may be in the shape of an agglomerate sphere (e.g., may be generally spherical), and may have an irregular shape even if the second primary particles NNP_2 agglomerate.

In an embodiment, the average particle diameter may indicate a particle diameter (D50) if a cumulative volume is about 50 volume% in a particle size distribution. In an embodiment, the average particle diameter (D50) of the second particle PTC2 may be a value measured using a particle size analyzer. The second particle PTC2 may have an average particle diameter (D50) of about 3 µm to about 20 µm, about 4 µm to about 15 µm, about 5 µm to about 10 µm, or about 3 µm to about 10 µm. For example, the second particle PTC2 may have an average particle diameter (D50) of about 8 µm.

The second primary particles NNP_2 constituting the second particle PTC2 may have an average size of about 3 µm or less. For example, the second primary particles NNP_2 may have an average size of about 300 nm to about 3 µm, about 0.5 µm to about 3 µm, about 1 µm to about 3 µm, or about 2 µm to about 3 µm. In an embodiment, the size of the second primary particles may indicate a diameter measured by randomly selecting about 30 primary particles from an electron micrograph of a positive electrode active material. The second primary particles NNP_2 may be uniform (e.g., substantially uniform) in size. The second primary particles NNP_2 may have a greater average size than the first primary particles SP1. A difference in average size between the second primary particles NNP_2 and the first primary particles NNP_2 may be about 300 nm or greater.

In an embodiment, the second particle PTC2 may include a second coating layer on a surface thereof. The second particle PTC2 may include the second coating layer, and may thus effectively prevent structural collapse (or reduce a likelihood or degree of structural collapse) caused by repeated charging/discharging.

The second coating layer may include an aluminium-containing compound, a magnesium-containing compound, or a combination thereof. Metal-containing compounds in the second coating layer may be, for example, metal oxides, metal hydroxides, metal carbonates, composites thereof, or mixtures thereof. The metal-containing compounds may further include other metals and/or non-metallic elements. For example, the second coating layer may further include lithium, manganese, and/or nickel.

A method of measuring the metal content in the second coating layer of the second particle PTC2 may include performing scanning electron microscopy and energy dispersive X-ray spectroscopy (SEM-EDS) on the second particle PTC2. Through the analysis described above, the content of aluminium and/or magnesium in the second coating layer may be determined. In addition to, or alternatively to, SEM-EDS, methods of measuring the metal content in the second coating layer may include inductively coupled plasma-mass spectrometry (ICP-MS), inductively coupled plasma optical emission spectroscopy (ICP-OES), and/or the like.

The first positive electrode active material layer ATL1 includes a first particle and a second particle. In the first positive electrode active material layer ATL1, the second particle PTC2 may be less than the first particle PTC1 in weight (or mass).

The first particle PTC1 and the second particle PTC2 constituting the first positive electrode active material layer ATL1 include manganese (Mn).

The second particle PTC2 has a high content of manganese (Mn), and may thus improve the operating voltage of a rechargeable battery compared to the first particle PTC1. In embodiments, the second particle PTC2 has a spinel structure, and may thus have a stable crystal structure and excellent lifetime characteristics compared to the first particle PTC1. The second particle PTC2 may have low resistance (e.g., low electrical resistance). In embodiments, the second particle PTC2, which is manganese oxide, is hardly usable alone due to its low capacity and energy density.

The positive electrode active material layer according to the present embodiment has the first particle PTC1 and the second particle PTC2 mixed together in a suitable or appropriate ratio (for example, the manganese (Mn) content is regulated), and may thus have improved voltage and lifetime characteristics compared to batteries including general lithium iron phosphate-based compounds or lithium manganese iron phosphate-based compounds. A battery having long service life may be obtainable by mixing the first particle PTC1 and the second particle PTC2 together in a suitable or appropriate range. The battery also has improved energy density, and may thus have excellent performance for commercial use.

The positive electrode active material layer according to the present embodiment has the first particle PTC1 and the second particle PTC2 mixed together in a suitable or appropriate ratio, and may thus allow an electrode plate to be easily prepared. For example, compared to preparing a positive electrode active material layer including general lithium iron phosphate compounds, the second particle PTC2 having a greater average particle diameter may be further included, and accordingly, the electrode plate may have increased bindability. Accordingly, a binder may be less utilized or required in the preparation of an electrode plate compared to preparing a positive electrode active material layer including the first particle PTC1 in the form of a single particle, having a very small average particle diameter. The first positive electrode active material layer ATL1 including the second particle PTC2 having low resistance (e.g., low electrical resistance) is formed first, and accordingly, the electrode plate may have improved resistance (e.g., improved electrical resistance).

### Second Positive Electrode Active Material Layer ATL2

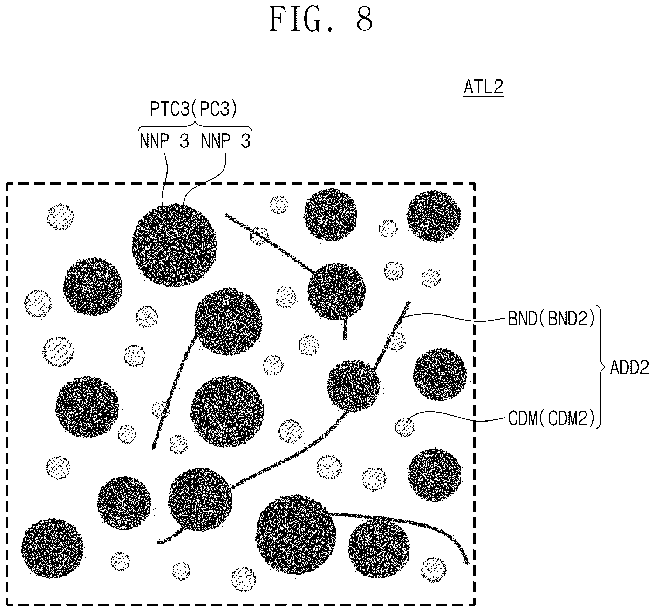

FIG. 8 is an enlarged view showing a second positive electrode active material layer ATL2 of a positive electrode for a rechargeable lithium battery according to embodiments of the present disclosure.

Referring to FIG. 8, the second positive electrode active material layer ATL2 may include a third particle PTC3 and a second functional additive ADD2. The second functional additive ADD2 may include a second binder BND2 and a second conductive material CDM2 (e.g., a second electrically conductive material CDM2).

The second binder BND2 may combine the third particle PTC3 and the second conductive material CDM2. In embodiments, the second binder BND2 may stably fix the second positive electrode active material layer ATL2 onto the first positive electrode active material layer ATL1. In an embodiment, the second binder BND2 may include at least one selected from the group consisting of polyvinyl alcohol, carboxymethyl cellulose, hydroxypropyl cellulose, diacetyl cellulose, polyvinyl chloride, carboxylated polyvinyl chloride, polyvinyl fluoride, an ethylene oxide-containing polymer, polyvinyl pyrrolidone, polyurethane, polytetrafluoroethylene, polyvinylidene fluoride, polyethylene, polypropylene, a styrene-butadiene rubber, a (meth)acrylated styrene-butadiene rubber, an epoxy resin, a (meth)acrylic resin, a polyester resin, and nylon, but is not limited thereto.

The second conductive material CDM2 may be used to improve conductivity (e.g., electrical conductivity) of the second positive electrode active material layer ATL2. Any suitable conductive material that does not cause chemical changes (e.g., does not cause undesirable chemical changes) in the second positive electrode active material layer ATL2 may be used as the second conductive material CDM2 without limitation. In an embodiment, the second conductive material CDM2 may include a carbon-based material such as natural graphite, artificial graphite, carbon black, acetylene black, ketjen black, a carbon fiber, a carbon nanofiber, and/or a carbon nanotube; a metal-based material including copper, nickel, aluminium, silver, etc. in a form of a metal powder and/or a metal fiber; a conductive polymer (e.g., an electrically conductive polymer) such as a polyphenylene derivative; or a mixture thereof.

### Third Particle PTC3

The third particle PTC3 includes an olivine-based lithium compound represented by Formula 3 below.

Formula 3 Liₐ₃Mn_{z3}Feₓ₃B3_{y3}PO_{4-c3}

In Formula 3 above, 0.8<a3≤1.2, 0.4≤z3≤0.8, 0≤x3≤0.6, 0≤y3≤0.05 (e.g. 0.001≤y3≤0.05), and 0≤c3≤0.05 are satisfied. B3 is at least one element selected from the group consisting of Al, Ti, V, and Mg. B3 may be a dopant with which the third particle PTC3 is doped. For example, B3 may include Ti.

The third particle PTC3 may further include carbon derived from the positive electrode active material layer AML1 described above. The third particle PTC3 may have a carbon element content of about 0.5 wt% to about 5 wt%, about 0.5 wt% to about 3 wt%, or about 0.5 wt% to about 2 wt%.

The third particle PTC3 may be in the form of a single particle. Herein, the term single particle may indicate a single type (or kind) of particle having no grain boundary inside thereof. The single particle may indicate one single particle morphologically present in an independent phase in which particles are not aggregated with one another, a particle having a monolith structure, a particle having a one-body structure, or a non-aggregated particle. For example, the single particle may be a single crystal. In embodiments, the single particle may be a particle including several crystals. The single particle may be in an isolated form. In embodiments, the single particle may be in a form in which about 2 to about 100 third primary particles NNP_3 are attached to one another.

The third particle PTC3 may be a nanomorphous positive electrode active material. The third particle PTC3 may include at least one third primary particle NNP_3. In an embodiment, the third particle PTC3 may be in the shape of sphere or oval (e.g., may be generally spherical or generally ovoid) in which third primary particles are attached. In another embodiment, the third particle PTC3 may not have a spherical shape but have an irregular shape even if the third primary particles NNP_3 are attached.

In an embodiment, the average particle diameter may indicate a particle diameter (D50) if a cumulative volume is about 50 volume% in a particle size distribution. In an embodiment, the average particle diameter (D50) of the third particle PTC3 may be a value measured using a particle size analyzer.

In an embodiment, the third particle PTC3 (e.g. in the form of a single particle) may have an average particle diameter of about 500 nm to about 2.5 µm, or about 1 µm. The size of at least one third primary particle NNP_3 constituting the third particle PTC3 may be measured using a scanning electron microscope (SEM). In an embodiment, the size of the third primary particle NNP_3 may indicate a diameter measured by randomly selecting about 30 third primary particles NNP_3 from an electron micrograph of a positive electrode active material. The third primary particles NNP_3 may be uniform (e.g., substantially uniform) in size. The third primary particle NNP_3 may have a size of about 100 nm to about 500 nm, or about 100 nm to about 200 nm.

The third particle PTC3 is in the form of polycrystal and may include secondary particles in which at least two third primary particles NNP_3 are aggregated. For example, one third particle PTC3 may include a plurality of third primary particles NNP_3 aggregated together. The third particle PTC3 composed of the plurality of third primary particles NNP_3 may be in the shape of sphere or oval (e.g., may be generally spherical or generally ovoid). Referring to FIG. 8, The third particle PTC3 in the form of polycrystal may be referred to as a polycrystalline third particle PC3.

In an embodiment, the average particle diameter may indicate a particle diameter (D50) if a cumulative volume is about 50 volume% in a particle size distribution. In an embodiment, the average particle diameter (D50) of the third particle PTC3 may be a value measured using a particle size analyzer.

The polycrystalline third particle PC3 including at least one third primary particle NNP_3 may have an average particle diameter of about 50 nm to about 5 µm, about 100 nm to about 3 µm, about 500 nm to about 2.5 µm, about 3 µm to about 7 µm, about 4 µm to about 6 µm, or about 5 µm. The average particle diameter (D50) of the third particle PTC3 may be smaller than the average particle diameter (D50) of the second particle PTC2 described above.

The third particle PTC3 may include at least one primary particle (or single particle). The size of at least one third primary particle NNP_3 constituting the third particle PTC3 may be measured using a scanning electron microscope (SEM). In an embodiment, the size of the third primary particle NNP_3 may indicate a diameter measured by randomly selecting about 30 third primary particles NNP_3 from an electron micrograph of a positive electrode active material. The third primary particles NNP_3 may be uniform (e.g., substantially uniform) in size.

At least one third primary particle NNP_3 constituting the polycrystalline third particle PC3 may have a size of about 100 nm to about 200 nm, about 50 nm to about 150 nm, about 50 nm to about 100 nm, about 100 nm to about 150 nm, or about 200 nm to about 300 nm.

In an embodiment, the third particle PTC3 may include a coating layer on a surface thereof. The coating layer may entirely cover the surface of the third particle PTC3, or may partially cover the surface of the third particle PTC3. For example, the coating layer may include carbon and/or a carbon-containing compound. The coating layer may further include at least one selected from the group consisting of a titanium-containing compound, a magnesium-containing compound, and a vanadium-containing compound. Metal-containing compounds, such as titanium-containing compounds, magnesium-containing compounds, and vanadium-containing compounds, may be, for example, metal oxides, metal hydroxides, metal carbonates, composites thereof, or mixtures thereof. The metal-containing compounds may further include other metals and/or non-metallic elements. For example, the metal-containing compounds may further include lithium. The third particle PTC3 may have improved structural stability and electrical conductivity through the coating layer.

In an embodiment, the third particle PTC3 may further include a grain boundary coating layer on a surface of each of the third primary particles NNP_3. The grain boundary coating layer may be present inside the third particle PTC3. The grain boundary coating layer may be formed to be applied along an interface between the third primary particles NNP_3 inside the third particle PTC3. For example, the grain boundary coating layer may indicate a material applied onto a grain boundary inside the third particle PTC3.

The grain boundary coating layer may include carbon and/or a carbon-containing compound. The grain boundary coating layer may further include at least one selected from the group consisting of a titanium-containing compound, a magnesium-containing compound, and a vanadium-containing compound.

The inside of the third particle PTC3 described above may indicate the entire inside portion of the third particle PTC3 excluding the surface of the third particle PTC3. For example, the inside of the third particle PTC3 may indicate a region of the entire inside from about 10 nm in depth, or from about 10 nm to about 2 µm in depth, with respect to the surface of the third particle PTC3.

The third particle PTC3 further includes a grain boundary coating portion, and may thus have greater structural stability and have a uniform (e.g., substantially uniform) coating layer formed on the surface thereof. In embodiments, the third particle PTC3 further includes a grain boundary coating portion, and may thus have further improved electrical conductivity.

The third particle PTC3 may further include carbon derived from the coating layer and/or the grain boundary coating layer described above. The third particle PTC3 may have a carbon element content of about 0.5 wt% to about 10 wt%, about 1 wt% to about 3 wt%, or about 1.5 wt% to about 2.5 wt%. For example, the third particle PTC3 may have a greater content of carbon if in the form of a secondary particle than in the form of a single particle.

The third particle PTC3 may be in the shape of sphere (e.g., may be generally spherical) in which a plurality of third primary particles NNP_3 are aggregated. The third particle PTC3 has the third primary particles NNP_3 closely aggregated, may thus exhibit the following characteristics. The third particle keeps the coating layer and/or the grain boundary coating layer described above well, and may thus have greater electrical conductivity and improved low-temperature characteristics. Due to the increased bindability of an electrode plate, binder capacity may be reduced. The third particle PTC3 may be in the shape of sphere or oval (e.g., may be generally spherical or generally ovoid).

The third particle PTC3 may have a porosity of about 20% to about 40%. A Span value of the third particle PTC3, analyzed through a particle size analyzer, may be about 0.3 to about 0.75.

Hereinafter, the positive electrode active material layer AML1 according to embodiments of the present disclosure will be described in more detail.

The positive electrode or positive electrode active material layer AML1 includes manganese (Mn). A total doping content of manganese (Mn) may be defined as the sum of a doping content M1 of manganese (Mn) included in the first positive electrode active material layer ATL1 and a doping content M2 of manganese (Mn) included in the second positive electrode active material layer ATL2. The doping content M1 of manganese (Mn) included in the first positive electrode active material layer ATL1 may be defined as the sum of a product of the manganese (Mn) doping content (z1 in Formula 1 described above) in the first particle PTC1 and a weight ratio (or amount) of the first particle PTC1, and a product of the manganese (Mn) doping content (x2 in Formula 2 described above) in the second particle PTC2 and a weight ratio (or amount) of the second particle PTC2. The doping content M2 of manganese (Mn) included in the second positive electrode active material layer ATL2 may be defined as a product of the manganese (Mn) doping content (z3 in Formula 3 described above) in the third particle PTC3 and a weight ratio (or amount) of the third particle PTC3.

The total doping content of manganese (Mn) in the positive electrode active material layer AML1 may be about 0.50 to about 0.90, about 0.50 to about 0.70, about 0.60 to about 0.80, about 0.60 to about 0.70, or about 0.50 to about 0.60. The total doping content of manganese may be calculated using the equation: Total Mn doping Content = [Number of Mn atoms in the first particle (z1) x Weight ratio of the first particle / Molecular weight of the first particle] + [Number of Mn atoms in the second particle (x2) x Weight ratio of the second particle / Molecular weight of the second particle] + [Number of Mn atoms in the third particle (z3) x Weight ratio of the third particle / Molecular weight of the third particle]. In the above equation, the weight ratio of the first particle may refer to the weight ratio of the first particle relative to the total weight of the first particle, the second particle, and the third particle.

The second particle PTC2 may be in an amount of about 5 wt% to about 20 wt%, about 10 wt% to about 20 wt%, about 15 wt% to about 30 wt%, about 20 wt% to about 30 wt%, or about 25 wt% to about 35 wt%, with respect to a total weight of the first particle PTC1 and the second particle PTC2 in the first positive electrode active material layer ATL1.

The positive electrode active material layer AML1 according to embodiments of the present disclosure may have a double layer structure in which the second positive electrode active material layer ATL2 is stacked on the first positive electrode active material layer ATL1. The positive electrode active material layer AML1 may include a functional additive ADD. The first positive electrode active material layer ATL1 may include a first functional additive ADD1, and the second positive electrode active material layer ATL2 may include a second functional additive ADD2. The functional additive ADD may indicate at least one of the first functional additive ADD1 or the second functional additive ADD2.

The functional additive may include a conductive material CDM (e.g., an electrically conductive material CDM) and a binder BND. The functional additive may be included, and accordingly, the positive electrode active material layer may have improved performance. For example, materials in a positive electrode active material layer may be well bonded, the bindability of an electrode plate may be improved, and the conductivity (e.g., electrical conductivity) of a positive electrode active material layer may be improved.

The first particle PTC1 in the form of a secondary particle may have a smaller amount of the functional additive ADD utilized or required for an active material than the first particle PTC1 in the form of a single particle. In embodiments, both the first particle PTC1 and the second particle PTC2 are included in the first positive electrode active material layer ATL1, and accordingly, a weight ratio (or amount) of the functional additive ADD utilized or required for an active material layer may be reduced.

For example, a relatively large amount of binder BND1 may be utilized or required to attach the first particle PTC1 having a small average particle diameter to the current collector COL1, but a relatively small amount of binder BND1 may be utilized or required to attach the second particle PTC2 having a large average particle diameter to the current collector COL1. A weight ratio (or amount) of the binder BND1 utilized or required through the first positive electrode active material layer ATL1 including the first particle PTC1 and the second particle PTC2 may be reduced.

The positive electrode active material layer AML1 of the present disclosure includes the first positive electrode active material layer ATL1 having a relatively small amount of functional additive utilized or required, and may thus improve energy density.

If the double layer structure is applied, an electrode plate may be more easily prepared. For example, the first positive electrode active material layer ATL1 in which the first particle PTC1 and the second particle PTC2 are mixed together may be first stacked on a current collector, and the second positive electrode active material layer ATL2 may be stacked on the first positive electrode active material layer ATL1. If the first positive electrode active material layer ATL1 having excellent bindability of an electrode plate is first stacked on a current collector, the binder BND1 may be less utilized or required, resulting in improved energy density. In embodiments, the first positive electrode active material layer ATL1 may be first stacked on a portion in contact with a current collector to improve the resistance (e.g., electrical resistance) of an electrode plate.

A weight ratio (or amount) of the first binder BND1 in the first positive electrode active material layer ATL1 may be about 1.2 wt% to about 3.0 wt% (e.g., based on 100 wt% of the first positive electrode active material layer ATL1).

A weight ratio (or amount) of the second binder BND2 in the second positive electrode active material layer ATL2 may be about 2.0 wt% to about 3.0 wt% (e.g., based on 100 wt% of the second positive electrode active material layer ATL2).

The weight ratio (or amount) of the first binder BND1 in the first positive electrode active material layer ATL1 may be lower than the weight ratio (or amount) of the second binder BND2 in the second positive electrode active material layer ATL2. In an embodiment, a ratio of the weight ratio (or amount) of the second binder BND2 to the weight ratio (or amount) of the first binder BND1 may be about 0.65 to about 4.5.

A weight ratio (or amount) of the first conductive material CDM1 in the first positive electrode active material layer ATL1 may be about 1.2 wt% to about 3.0 wt% (e.g., based on 100 wt% of the first positive electrode active material layer ATL1).

A weight ratio (or amount) of the second conductive material CDM2 in the second positive electrode active material layer ATL2 may be about 2.0 wt% to about 3.0 wt% (e.g., based on 100 wt% of the second positive electrode active material layer ATL2).

The weight ratio (or amount) of the first conductive material CDM1 in the first positive electrode active material layer ATL1 may be lower than the weight ratio (or amount) of the second conductive material CDM2 in the second positive electrode active material layer ATL2. In an embodiment, a ratio of the weight ratio (or amount) of the second conductive material CDM2 to the weight ratio (or amount) of the first conductive material CDM1 may be about 0.6 to about 2.6.

A weight ratio (or amount) of the first functional additive ADD1 in the first positive electrode active material layer ATL1 may be about 2.4 wt% to about 6.0 wt% (e.g., based on 100 wt% of the first positive electrode active material layer ATL1).

A weight ratio (or amount) of the second functional additive ADD2 in the second positive electrode active material layer ATL2 may be about 4.0 wt% to about 6.0 wt% (e.g., based on 100 wt% of the second positive electrode active material layer ATL2).

The weight ratio (or amount) of the first functional additive ADD1 in the first positive electrode active material layer ATL1 may be lower than the weight ratio (or amount) of the second functional additive ADD2 in the second positive electrode active material layer ATL2.

In an embodiment, a ratio of the weight ratio (or amount) of the second functional additive to the weight ratio (or amount) of the first functional additive may be about 1.0 to about 2.0, about 1.5 to about 2.5, or about 1.5 to about 3.0.

The first positive electrode active material layer ATL1 may have a thickness (T1). In an embodiment, T1 may increase with a rise in weight of the first particle PTC1 and the second particle PTC2 included in the first positive electrode active material layer ATL1. The second positive electrode active material layer ATL2 may have a thickness (T2). In an embodiment, T2 may increase with a rise in weight of the third particle PTC3 included in the second positive electrode active material layer ATL2. In an embodiment, a ratio of T2 to T1 (T2/T1) may be about 0.4 to about 2.0, about 0.8 to about 1.5, about 0.9 to about 1.2, about 0.8 to about 1.2, or about 1. Within the ranges described above, stability and lifetime characteristics may be improved while excellent high voltage performance and energy density are maintained.

In an embodiment, the positive electrode active material layer AML1 of the present disclosure may have a compressed (e.g. pellet) density of about 2.3 g/cc to about 2.8 g/cc.

In an embodiment, the first positive electrode active material layer ATL1 may have a loading level of about 5 mg/cm² to about 10 mg/cm². The second positive electrode active material layer ATL2 may have a loading level of about 5 mg/cm² to about 25 mg/cm².

A rechargeable lithium battery including the positive electrode active material of the present disclosure may have improved low-temperature characteristics. In an embodiment, capacity at -20 °C relative to initial capacity (capacity at -20 °C/initial capacity) of the rechargeable lithium battery may be about 40% or greater. For example, capacity at -20 °C relative to initial capacity (capacity at -20 °C/initial capacity) of the rechargeable lithium battery of the present disclosure may be about 40% to about 100%, about 50% to about 100%, or about 96% to about 99%.

A rechargeable lithium battery including the positive electrode active material of the present disclosure may have improved operating voltage. In an embodiment, the rechargeable lithium battery of the present disclosure may have an operating voltage range of about 3 V to about 5 V. For example, the operating voltage range may be about 3 V to about 4.5 V, or about 3.5 V to about 4 V.

A rechargeable lithium battery including the positive electrode active material of the present disclosure may have improved lifetime characteristics. In an embodiment, the rechargeable lithium battery of the present disclosure may have a capacity retention of about 98% or greater after 50 times of charging/discharging at a constant current of 0.1 C at the voltage described above. For example, the capacity retention may be about 98% to about 100%, or about 99.8% to about 100%.

### Method for Preparing Positive Electrode Active Material

Hereinafter, Preparation Examples, Examples, and Comparative Examples of the present disclosure will be described. However, the following Examples are presented only as embodiments of the present disclosure, and the present disclosure is not limited by the following Examples.

### Preparation Example 1: Preparation of First Particle PTC1 in the form of Single Particle

A manganese iron phosphate precursor (Mn_{0.6}Fe_{0.4}PO₄), lithium carbonate, and titanium dioxide were mixed together at a molar ratio of 1:1.03:0.004. 10 wt% of glucose was added to the resultant mixture. The mixture was subjected to a wet grinding process through ball milling. The mixture was evaporated to dryness on a heating tray and then placed and dried in a vacuum oven at 120 °C for 4 hours. The dried mixture was fired at 750 °C for 10 hours in a nitrogen atmosphere. The resultant fired product was ground to obtain a first particle in the form of a single particle. The first particle contained primary particles having an average size of about 100 nm to about 200 nm.

### Preparation Example 2: Preparation of Second Particle PTC2 in the form of Secondary Particle

0.170 g of MnSO₄H₂O and 0.228 g of (NH₋₄)₂S₂-O₈ were dissolved in 100 ml of distilled water, sulfuric acid was added thereto to adjust the pH to 1, and the resultant mixture was subjected to a reaction at 130 °C for 10 hours to obtain a solid precipitate. The obtained precipitate was washed with distilled water several times and dried at 300 °C for 3 hours to obtain MnO₂ having an average particle diameter of 5 µm as a solid.

Li₂CO₃ and synthesized MnO₂ were mixed together such that Li and Mn were at a molar ratio of 1:2, and the resultant mixture was heated at 600 °C for 10 hours to synthesize LiMn₂O₄ particles having an average particle diameter of 7 µm and an average primary particle size of 0.5 µm to 2.5 µm.

### Preparation Example 3: Preparation of Third Particle PTC3 in the form of Secondary Particle

A manganese iron phosphate precursor (Mn_{0.6}Fe_{0.4}PO₄), lithium carbonate, and titanium dioxide were mixed together at a molar ratio of 1:1.03:0.004. 10 wt% of glucose was further added to the resultant mixture. The resultant slurry mixture was spray-dried and evaporated to dryness at a spray pressure of 0.5 MPa and a temperature of 230 °C. The dried mixture was fired at 750 °C for 10 hours in a nitrogen atmosphere to obtain a third particle in the form of a secondary particle. Primary particles in the third particle had an average size of about 50 nm to about 150 nm.

### Preparation of Single Layer Electrode Plate

### Comparative Example 1-1

The first particle of Preparation Example 1 and the second particle of Preparation Example 2 were mixed together at a molar ratio of 30:70 and dispersed in N-methylpyrrolidone along with a conductive material (carbon black) and a binder (polyvinylidene fluoride) to prepare a positive electrode active material slurry. The positive electrode active material slurry was applied onto a positive electrode current collector and dried to prepare a single layer electrode plate. The total Mn doping content for Comparative Example 1-1 was calculated as follows.

Given that the molecular weights of the first particle and the second particle are approximately 157.21 and 180, respectively, and the numbers of Mn atoms per mole of the first particle and the second particle are 0.6 and 2, respectively, the Mn doping content amount can be calculated using the following equation (described earlier in this specification):

Total Mn doping content = [(30 x 0.6) / 157.21] + ([70 x 2) / 180] = 0.1145 + 0.7778 = 0.8923 (which can be rounded to 0.9).

### Comparative Example 1-2

Except that the first particle of Preparation Example 1 and the second particle of Preparation Example 2 were mixed together at a molar ratio of 42:58, a positive electrode active material slurry and a single layer electrode plate were prepared in the same manner as in Comparative Example 1-1.

### Comparative Example 1-3

Except that the first particle of Preparation Example 1 and the second particle of Preparation Example 2 were mixed together at a molar ratio of 56:44, a positive electrode active material slurry and a single layer electrode plate were prepared in the same manner as in Comparative Example 1-1.

### Comparative Example 1-4

Except that the first particle of Preparation Example 1 and the second particle of Preparation Example 2 were mixed together at a molar ratio of 70:30, a positive electrode active material slurry and a single layer electrode plate were prepared in the same manner as in Comparative Example 1-1.

### Comparative Example 1-5

Except that the first particle of Preparation Example 1 and the second particle of Preparation Example 2 were mixed together at a molar ratio of 83:17, a positive electrode active material slurry and a single layer electrode plate were prepared in the same manner as in Comparative Example 1-1.

### Comparative Example 1-6

Except that the first particle of Preparation Example 1 and the second particle of Preparation Example 2 were mixed together at a molar ratio of 95:5, a positive electrode active material slurry and a single layer electrode plate were prepared in the same manner as in Comparative Example 1-1.

### Comparative Example 1-7

Except that the first particle of Preparation Example 1, the second particle of Preparation Example 2, and the third particle of Preparation Example 3 were mixed together at a molar ratio of 41.5:17:41.5, a positive electrode active material slurry and a single layer electrode plate were prepared in the same manner as in Comparative Example 1-1.

### Preparation of Double Layer Electrode Plate

### Example 1-1

The first particle of Preparation Example 1 and the second particle of Preparation Example 2 were dispersed in N-methylpyrrolidone along with a conductive material (carbon black) and a binder (polyvinylidene fluoride) to prepare a first positive electrode active material slurry. The third particle of Preparation Example 3 was dispersed in N-methylpyrrolidone along with a conductive material (carbon black) and a binder (polyvinylidene fluoride) to prepare a second positive electrode active material slurry.

The first positive electrode active material slurry was applied onto a positive electrode current collector and dried to form a first positive electrode active material layer. The second positive electrode active material slurry was applied onto the first positive electrode active material layer and dried to form a second positive electrode active material layer.

In this case, an active material layer was formed such that the first particle, the second particle, and the third particle in the double layer positive electrode were present at a molar ratio of 41.5:17:41.5. Through a roll press, a positive electrode in which the current collector, the first positive electrode active material layer, and the second positive electrode active material layer were stacked in this order was prepared.

### Example 1-2

The first particle of Preparation Example 1 and the second particle of Preparation Example 2 were dispersed in N-methylpyrrolidone along with a conductive material (carbon black) and a binder (polyvinylidene fluoride) to prepare a first positive electrode active material slurry. The third particle of Preparation Example 3 was dispersed in N-methylpyrrolidone along with a conductive material (carbon black) and a binder (polyvinylidene fluoride) to prepare a second positive electrode active material slurry.

The first positive electrode active material slurry was applied onto a positive electrode current collector and dried to form a first positive electrode active material layer. The second positive electrode active material slurry was applied onto the first positive electrode active material layer and dried to form a second positive electrode active material layer.

In this case, an active material layer was formed such that the first particle, the second particle, and the third particle in the double layer positive electrode were present at a molar ratio of 35:30:35. Through a roll press, a positive electrode in which the current collector, the first positive electrode active material layer, and the second positive electrode active material layer were stacked in this order was prepared.

### Comparative Example 2-1

The first particle of Preparation Example 1 and the second particle of Preparation Example 2 were dispersed in N-methylpyrrolidone along with a conductive material (carbon black) and a binder (polyvinylidene fluoride) to prepare a first positive electrode active material slurry. The third particle of Preparation Example 3 was dispersed in N-methylpyrrolidone along with a conductive material (carbon black) and a binder (polyvinylidene fluoride) to prepare a second positive electrode active material slurry.

Unlike Example 1-1, the second positive electrode active material slurry was first applied onto a positive electrode current collector and dried to form a first positive electrode active material layer. Thereafter, the first positive electrode active material slurry was applied onto the first positive electrode active material layer and dried to form a second positive electrode active material layer.

In this case, an active material layer was formed such that the first particle, the second particle, and the third particle in the double layer positive electrode were present at a molar ratio of 41.5:17:41.5. Through a roll press, a positive electrode in which the current collector, the first positive electrode active material layer, and the second positive electrode active material layer were stacked in this order was prepared.

### Comparative Example 2-2

The first particle of Preparation Example 1 and the second particle of Preparation Example 2 were dispersed in N-methylpyrrolidone along with a conductive material (carbon black) and a binder (polyvinylidene fluoride) to prepare a first positive electrode active material slurry. The third particle of Preparation Example 3 was dispersed in N-methylpyrrolidone along with a conductive material (carbon black) and a binder (polyvinylidene fluoride) to prepare a second positive electrode active material slurry.

Unlike Example 1-2, the second positive electrode active material slurry was first applied onto a positive electrode current collector and dried to form a first positive electrode active material layer. Thereafter, the first positive electrode active material slurry was applied onto the first positive electrode active material layer and dried to form a second positive electrode active material layer.

In this case, an active material layer was formed such that the first particle, the second particle, and the third particle in the double layer positive electrode were present at a molar ratio of 35:30:35. Through a roll press, a positive electrode in which the current collector, the first positive electrode active material layer, and the second positive electrode active material layer were stacked in this order was prepared.

### Preparation of Negative Electrode

Graphite, a binder, and a conductive material were mixed together in an N-methylpyrrolidone solvent to prepare a negative electrode active material slurry. The negative electrode active material slurry was applied onto a copper current collector, dried, and rolled to prepare a negative electrode.

### Preparation of Rechargeable Lithium Battery

A coin half-cell was prepared using the prepared positive electrode and negative electrode. A polypropylene film (Celgard 3510) was used as a separator. As an electrolyte, an electrolyte solution obtained by mixing 1.3 M LiPF₆ together with a mixed solvent of ethylene carbonate (EC), diethyl carbonate (DEC), and fluoroethylene carbonate (FEC) (volume ratio: 2:6:2) was used.

### Evaluation Example 1: Analysis of Positive Electrode Active Material Surface

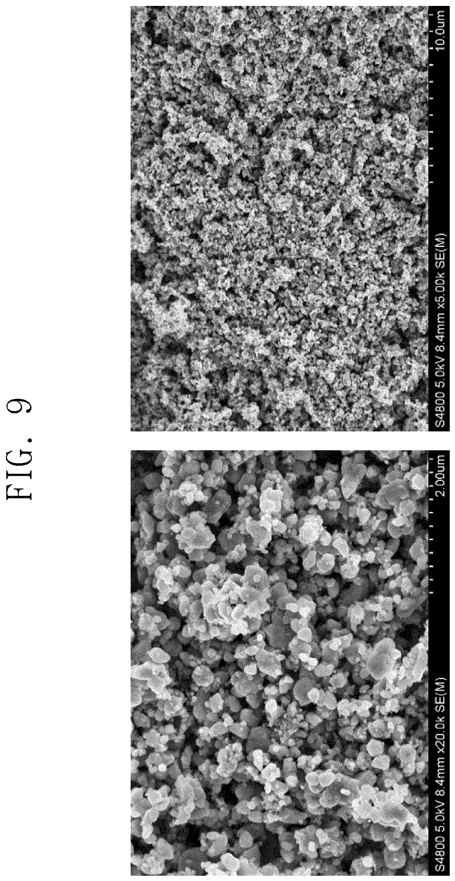

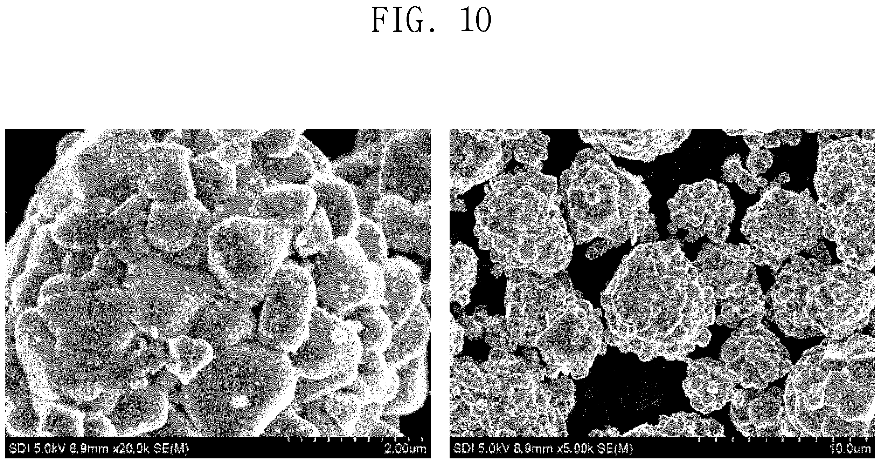

An SEM image of the first particle prepared in Preparation Example 1 is shown in FIG. 9. An SEM image of the second particle prepared in Preparation Example 2 is shown in FIG. 10. Referring to FIG. 9, it can be seen that the first particle according to an embodiment of the present disclosure is in the form of a single particles in which nano-sized fine primary particles are present individually or several primary particles are randomly aggregated. Referring to FIG. 10, it can be seen that the second particle according to an embodiment of the present disclosure is in the form of a secondary particle in which a plurality of primary particles are aggregated. Compared to the first particle, the second particle takes a variety of forms and has large primary particles.

### Evaluation Example 2: Analysis of Positive Electrode Properties

Pellet density (PD) and energy density (ED) of the positive electrode active material layers prepared according to Examples 1-1 and 2-2 and Comparative Examples 1-1 to 2-2 were measured, and the results are shown in Table 1.

**Table 1**

| | Electrode plate structure | Powder | | | | | |
|---|---|---|---|---|---|---|---|
| | | First particle | Second particle | Third particle | Mn content | PD (g/cc) | ED (Wh/kg) |
| Comparative Example 1-1 | Single layer | 30% | 70% | - | 0.90 | 2.60 | 442 |
| Comparative Example 1-2 | Single layer | 42% | 58% | - | 0.80 | 2.57 | 455 |
| Comparative Example 1-3 | Single layer | 56% | 44% | - | 0.70 | 2.52 | 469 |
| Comparative Example 1-4 | Single layer | 70% | 30% | - | 0.60 | 2.43 | 483 |
| Comparative Example 1-5 | Single layer | 83% | 17% | - | 0.50 | 2.40 | 495 |
| Comparative Example 1-6 | Single layer | 95% | 5% | - | 0.40 | 2.25 | 506 |
| Comparative Example 1-7 | Single layer | 41.5% | 17% | 41.5% | 0.50 | 2.45 | 497 |
| Comparative Example 2-1 | Double layer | 41.5% | 17% | 41.5% | 0.50 | 2.41 | 493 |
| Comparative Example 2-2 | Double layer | 35% | 30% | 35% | 0.50 | 2.40 | 477 |
| Example 1-1 | Double layer | 41.5% | 17% | 41.5% | 0.50 | 2.43 | 497 |
| Example 1-2 | Double layer | 35% | 30% | 35% | 0.60 | 2.42 | 480 |

Referring to Table 1, it can be seen that the positive electrode active material layers according to Examples 1-1 and 1-2 have higher energy density than Comparative Examples 1-1 to 1-4. In addition, even if compared to Comparative Examples 1-4, 1-5, or 1-7, each having a single layer structure, the positive electrode active material layers according to Examples 1-1 to 2-2 are capable of keeping the pellet density and the energy density at similar levels. It has been determined that the positive electrode active material layers according to Examples above have a high energy density of 480 Wh/kg or greater, indicating that the positive electrode active material layers have an energy density suitable for commercial use.

### Evaluation Example 3: Evaluation of Battery Properties

Properties of rechargeable lithium batteries prepared using the positive electrodes of Examples 1-1 and 1-2 and Comparative Examples 1-1 to 2-2 were evaluated.

For initial charging/discharging, the rechargeable lithium batteries were initially charged at a constant current of 0.2 C and a constant voltage of 4.25 V, and after 10 minutes of rest, discharged up to 2.5 V at a constant current of 0.2 C. Thereafter, the charging/discharging was repeated 50 times at 45 °C and 1.0 C/1.0 C. In addition, a coin cell was additionally prepared and measured at -20 °C for a capacity of 0.2 C. The results of evaluating the battery properties are shown in Table 2 below.

**Table 2**

| | 0.2 C charge amount (mAh/g) | 0.2 C discharge amount (mAh/g) | 0.2 C efficiency | -20 capacity (mAh/g) | Average voltage (V) | 1 C lifetime (%,@50cy) | DCIR, SOC50 (Ω,0.2 C/1.0 C) |
|---|---|---|---|---|---|---|---|
| Comparative Example 1-1 | 124.9 | 120.4 | 96.4% | 60 | 3.87 | 98.6 | 22.0 |
| Comparative Example 1-2 | 130.1 | 124.6 | 95.8% | 65 | 3.82 | 98.1 | 25.6 |
| Comparative Example 1-3 | 136.1 | 129.5 | 95.2% | 72 | 3.77 | 97.6 | 29.8 |
| Comparative Example 1-4 | 142.1 | 134.4 | 94.6% | 78 | 3.71 | 97.3 | 34.0 |
| Comparative Example 1-5 | 147.7 | 139.0 | 94.1% | 84 | 3.66 | 96.5 | 37.9 |
| Comparative Example 1-6 | 152.9 | 143.2 | 93.7% | 89 | 3.62 | 94.6 | 41.5 |
| Comparative Example 1-7 | 148.2 | 140.3 | 94.7% | 101 | 3.66 | 96.9 | 35.5 |
| Comparative Example 2-1 | 147.2 | 139.8 | 95.0% | 67 | 3.66 | 97.9 | 28.6 |
| Comparative Example 2-2 | 142.3 | 135.7 | 95.4% | 89 | 3.66 | 98.3 | 26.9 |
| Example 1-1 | 148.3 | 140.9 | 95.0% | 72 | 3.66 | 98.4 | 23.6 |
| Example 1-2 | 143.4 | 136.8 | 95.4% | 94 | 3.66 | 98.9 | 21.9 |

Referring to Table 2, it can be seen that the positive electrodes according to Examples 1-1 and 1-2 had improved capacity retention after at least 50 cycles at 1 C rate, compared to the single layer positive electrodes of Comparative Examples 1-4, 1-5, or 1-7.

The positive electrodes according to Examples 1-1 and 1-2 are positive electrodes in which the first particle, the second particle, and the third particle are suitably or appropriately mixed together, and may be used as long-life positive electrodes having excellent characteristics considering average voltage, energy density, and lifetime characteristics overall.

Compared to a single layer structure including the same active material, if a double layer structure is applied, active materials have improved bindability and stability, thereby improving battery performance. Functional additives are less utilized or required in the preparation of positive electrodes, and in turn, energy density may be improved.

In addition, the second particle having low resistance (e.g., low electrical resistance) is included in the first positive electrode active material layer in contact with the current collector, thereby reducing the resistance (e.g., electrical resistance) of the positive electrode. It can be seen that if compared to Comparative Examples 1-4, 1-5, and 1-7, the positive electrode according to Examples of the present disclosure has significantly reduced resistance (e.g., electrical resistance), and even if compared to Comparative Examples 2-1 and 2-2, each having the same double layer structure, the positive electrode according to Examples of the present disclosure has significantly reduced resistance (e.g., electrical resistance).

### Evaluation Example 4: Weight ratio of Functional Additive in Active Material Layer

Weight ratios (or amounts) of functional additives utilized or required for preparing the positive electrodes in the single layer structures of Comparative Examples 1-1 to 1-7 were measured.

The weight ratios (or amounts) of the functional additives in the first positive electrode active material layers and the weight ratios of the functional additives in the second positive electrode active material layers utilized or required for preparing the positive electrodes in the double layer structures of Comparative Examples 2-1 and 2-2 were measured.

The weight ratios (or amounts) of the functional additives in the first positive electrode active material layers and the weight ratios (or amounts) of the functional additives in the second positive electrode active material layers in the positive electrodes of Examples 1-1 and 1-2 were measured. The weight ratios (or amounts) of the functional additives in the active material layers are shown in Table 3 below.

**Table 3**

| | Electrode plate structure | Weight ratio (or amount) of functional additive in active material layer | |
|---|---|---|---|
| | | Positive electrode active material layer AML1 | |
| | | First positive electrode active material layer ATL1 | Second positive electrode active material layer ATL2 |
| Comparative Example 1-1 | Single layer | 4.0 wt% | |
| Comparative Example 1-2 | Single layer | 4.0 wt% | |
| Comparative Example 1-3 | Single layer | 4.0 wt% | |
| Comparative Example 1-4 | Single layer | 4.0 wt% | |
| Comparative Example 1-5 | Single layer | 4.0 wt% | |
| Comparative Example 1-6 | Single layer | 4.0 wt% | |
| Comparative Example 1-7 | Single layer | 4.0 wt% | |
| Comparative Example 2-1 | Double layer | 4.0 wt% | 2.4 wt% |
| Comparative Example 2-2 | Double layer | 4.0 wt% | 2.4 wt% |
| Example 1-1 | Double layer | 2.4 wt% | 4.0 wt% |
| Example 1-2 | Double layer | 2.4 wt% | 4.0 wt% |

According to the Examples of the present disclosure, the weight ratio (or amount) in the first positive electrode active material layer may be lower than the weight ratio (or amount) in the second positive electrode active material layer.

Unlike the Examples of the present disclosure, in Comparative Examples 2-1 and 2-2, the active materials forming the first positive electrode active material layer and the active materials forming the second positive electrode active material layer were formed in reverse. In this case, it is seen that functional additives are required in larger quantities to form the first positive electrode active material layer on the current collector.

According to embodiments of the present disclosure, the functional additive may be less utilized or required to stack the first positive electrode active material layer on the current collector, and in turn, preparing an electrode plate may be facilitated by first forming the first positive electrode active material layer in combination with the first positive electrode active material slurry, which is easy to prepare the positive electrode.

If compared with Comparative Examples 1-4 and 1-5 of a single layer structure having the same proportion of a positive electrode active material as the Examples according to embodiments of the present disclosure, it can be seen that a total amount of functional additives is less in the Examples according to embodiments of the present disclosure.

For example, Comparative Example 1-4 utilizes functional additives in an amount of 4.0 wt% with respect to the positive electrode active material layer, which means 4.0 parts by weight with respect to 100 parts by weight of the positive electrode active material layer.

Example 1-2 utilizes the first functional additive in an amount of 2.4 wt% with respect to the first positive electrode active material layer, and the second functional additive in an amount of 4.0 wt% with respect to the second positive electrode active material layer.

With respect to 100 parts by weight of the positive electrode active material layer, the first positive electrode active material layer is in an amount of 70 parts by weight and the second positive electrode active material layer is in an amount of 30 parts by weight, and thus the first functional additive is in an amount of 1.68 parts by weight (=70 x 0.024) and the second functional additive is in an amount of 1.2 parts by weight (=30 x 0.04), and accordingly, the functional additives are in an amount of 2.88 parts by weight with respect to 100 parts by weight of the positive electrode active material layer.

As described above, if compared to a single layer structure, the amount of functional additives with respect to 100 parts by weight of the active material layer is reduced, and accordingly, the active material layer may have improved energy density. In addition, the entire positive electrode may have reduced resistance (e.g., electrical resistance) values by forming the first positive electrode active material layer in contact with a current collector, with an active material having low resistance (e.g., low electrical resistance).

A positive electrode according to the present disclosure includes a first positive electrode active material layer including an olivine-based first particle having a size of hundreds of nanometers and a spinel-based second particle having a size of several micrometers, and a second positive electrode active material layer including an olivine-based third particle having a size of several micrometers and stacked on the first active material layer, and may thus have improved pellet density, capacity, and energy density. In the positive electrode according to embodiments of the present disclosure, an electrode plate may be readily prepared and have improved resistance (e.g., electrical resistance). A rechargeable lithium battery according to embodiments of the present disclosure may have relatively improved lifetime.

The descriptions provided above are for example embodiments for implementing the subject matter of the present disclosure. The present disclosure will include both the embodiments described above and embodiments that may be easily modified or simply changed in design. In addition, the present disclosure will also include technologies that may be easily modified and implemented using embodiments. Therefore, the scope of the present disclosure should not be limited to the embodiments described above, but should be defined by the following claims as well as the equivalents thereof.

## Claims

1. A positive electrode for a rechargeable lithium battery, comprising:
a current collector;
a first positive electrode active material layer on the current collector; and
a second positive electrode active material layer on the first positive electrode active material layer,
wherein the first positive electrode active material layer comprises a first particle comprising an olivine structured compound represented by Formula 1 below and having the form of a single particle, and a second particle comprising a spinel structured compound represented by Formula 2 below,
the second positive electrode active material layer comprises a third particle comprising an olivine structured compound represented by Formula 3 below and having the form of a secondary particle in which a plurality of primary particles are aggregated, and
the first particle has a greater weight than the second particle,
Formula 1 Liₐ₁Mn_{z1}Feₓ₁B1_{y1}PO_{4-c1}
wherein in Formula 1 above, B1 is at least one element selected from the group consisting of Al, Ti, V, and Mg, and 0.8<a1≤1.2, 0.4≤z1≤0.8, 0.2≤x1≤0.6, 0≤y1≤0.05, and 0≤c1≤0.05 are satisfied,
Formula 2 Liₐ₂Mnₓ₂B2_{y2}O_{4-c2}
wherein in Formula 2 above, B2 is at least one element selected from the group consisting of Al and Mg, and 0.8<a2≤1.2, 1.9≤x2≤2.05, 0≤y2≤0.05, and 0≤c2≤0.05 are satisfied, and
Formula 3 Liₐ₃Mn_{z3}Feₓ₃B3_{y3}PO_{4-c3}
wherein in Formula 3 above, B3 is at least one element selected from the group consisting of Al, Ti, V, and Mg, and 0.8<a3≤1.2, 0.4≤z3≤0.8, 0≤x3≤0.6, 0≤y3≤0.05, and 0≤c3≤0.05 are satisfied.

2. The positive electrode for a rechargeable lithium battery as claimed in claim 1, wherein with respect to a total weight of the first particle, the second particle, and the third particle in the positive electrode, the second particle is in an amount of about 15 wt% to about 30 wt%.

3. The positive electrode for a rechargeable lithium battery as claimed in claim 1 or claim 2, wherein a thickness ratio of the second positive electrode active material layer to the first positive electrode active material layer is about 0.8 to about 1.2.

4. The positive electrode for a rechargeable lithium battery as claimed in any one of claims 1 to 3, wherein a total doping content of manganese (Mn) in the positive electrode is about 0.50 to about 0.60.

5. The positive electrode for a rechargeable lithium battery as claimed in any one of claims 1 to 4, wherein the second particle is in the form of a secondary particle in which a plurality of primary particles are aggregated, and
the secondary particle has an average particle diameter (D50) of about 3 µm to about 10 µm.

6. The positive electrode for a rechargeable lithium battery as claimed in any one of claims 1 to 5, wherein the plurality of primary particles of the third particle have an average size of about 50 nm to about 150 nm, and
the third particle has an average particle diameter (D50) of about 3 µm to about 7 µm.

7. The positive electrode for a rechargeable lithium battery as claimed in any one of claims 1 to 6, wherein the third particle has a porosity of about 20% to about 40%.

8. The positive electrode for a rechargeable lithium battery as claimed in any one of claims 1 to 7, wherein a Span value of the third particle, analyzed through a particle size analyzer, is about 0.3 to about 0.75.

9. A positive electrode for a rechargeable lithium battery, comprising:
a current collector;
a first positive electrode active material layer on the current collector; and
a second positive electrode active material layer on the first positive electrode active material layer,
wherein the first positive electrode active material layer comprises a first particle comprising an olivine structured compound represented by Formula 1 below and having the form of a single particle, and a second particle comprising a spinel structured compound represented by Formula 2 below, and a first functional additive,
the second positive electrode active material layer comprises a third particle comprising an olivine structured compound Formula 3 below and having the form of a secondary particle in which a plurality of primary particles are aggregated, and a second functional additive,
the first functional additive and the second functional additive each comprise a conductive material and a binder, and
the first functional additive in the first positive electrode active material layer has a lower weight ratio than the second functional additive in the second positive electrode active material layer,
Formula 1 Liₐ₁Mn_{z1}Feₓ₁B1_{y1}PO_{4-c1}
wherein in Formula 1 above, B1 is at least one element selected from the group consisting of Al, Ti, V, and Mg, and 0.8<a1≤1.2, 0.4≤z1≤0.8, 0.2≤x1≤0.6, 0≤y1≤0.05, and 0≤c1≤0.05 are satisfied,
Formula 2 Liₐ₂Mnₓ₂B2_{y2}O_{4-c2}
wherein in Formula 2 above, B2 is at least one element selected from the group consisting of Al and Mg, and 0.8<a2≤1.2, 1.9≤x2≤2.05, 0≤y2≤0.05, and 0≤c2≤0.05 are satisfied, and
Formula 3 Liₐ₃Mn_{z3}Feₓ₃B3_{y3}PO_{4-c3}
wherein in Formula 3 above, B3 is at least one element selected from the group consisting of Al, Ti, V, and Mg, and 0.8<a3≤1.2, 0.4≤z3≤0.8, 0≤x3≤0.6, 0≤y3≤0.05, and 0≤c3≤0.05 are satisfied.

10. The positive electrode for a rechargeable lithium battery as claimed in claim 9, wherein a ratio of the weight ratio of the second functional additive to the weight ratio of the first functional additive is about 1.5 to about 3.0.

11. The positive electrode for a rechargeable lithium battery as claimed in claim 9 or claim 10, wherein the weight ratio of the first functional additive is about 2.4 wt% to about 6.0 wt%.

12. The positive electrode for a rechargeable lithium battery as claimed in any one of claims 9 to 11, wherein the weight ratio of the second functional additive is about 4.0 wt% to about 6.0 wt%.

13. The positive electrode for a rechargeable lithium battery as claimed in any one of claims 9 to 12, wherein a thickness ratio of the second positive electrode active material layer to the first positive electrode active material layer is about 0.8 to about 1.2.

14. The positive electrode for a rechargeable lithium battery as claimed in any one of claims 9 to 13, wherein the second particle is in the form of a secondary particle in which a plurality of primary particles are aggregated, and
the secondary particle has an average particle diameter (D50) of about 3 µm to about 10 µm.

15. The positive electrode for a rechargeable lithium battery as claimed in any one of claims 9 to 14, wherein with respect to a total weight of the first particle, the second particle, and the third particle in the positive electrode, a total weight of the second particle is about 15 wt% to about 30 wt%.
